# EUROPÄISCHE PATENTSCHRIFT

(11) **EP 2 435 603 B1**
(45) Veröffentlichungstag und Bekanntmachung des Hinweises auf die Patenterteilung: **13.03.2013**
(21) Anmeldenummer: 10721152.6
(22) Anmeldetag: 20.05.2010
(51) Int. Cl.: C23C 14/02, C23C 14/16, C23C 14/58, C23C 28/02, C22C 1/02, B32B 15/01, C22C 38/00, C25D 5/50

(54) **VERFAHREN ZUM HERSTELLEN EINES STAHLFLACHPRODUKTS UND STAHLFLACHPRODUKT**
PROCESS OF MANUFACTURING A FLAT STEEL PRODUCT AND FLAT STEEL PRODUCT
PROCÉDÉ DE FABRICATION D'UN PRODUIT PLAT EN ACIER ET PRODUIT PLAT EN ACIER

(30) Priorität: 25.05.2009 DE 102009022515
(43) Veröffentlichungstag der Anmeldung: 04.04.2012
(73) Patentinhaber: ThyssenKrupp Steel Europe AG, 47166 Duisburg (DE)
(72) Erfinder: SCHUHMACHER, Bernd, 44227 Dortmund (DE); SCHWERDT, Christian, 47051 Duisburg (DE); WEIHER, Nicole, 44879 Bochum (DE); WEINHOLD, Richard, 41464 Neuss (DE)
(74) Vertreter: Cohausz & Florack
(86) Internationale Anmeldenummer: PCT/EP2010/056974
(87) Internationale Veröffentlichungsnummer: WO 2010/136383

(56) Entgegenhaltungen:
- WO-A1-2006/089832
- WO-A2-2009/059950
- SCHUHMACHER B ET AL: "Novel coating systems based on PVD for steel sheet" VAKUUM IN FORSCHUNG UND PRAXIS, Bd. 13, Nr. 4, August 2001 (2001-08), Seiten 233-235, XP002389830 WILEY-VCH, WEINHEIM [DE] ISSN: 0947-076X DOI: 10.1002/1522-2454(200108)13:4<233::AID-VIP R233>3.0.CO;2-B

## Beschreibung

Die Erfindung betrifft ein Verfahren zum Herstellen eines Stahlflachprodukts, das aus einer aus einem Stahlwerkstoff bestehenden Grundschicht und einem darauf aufgetragenen, vor Korrosion schützenden mehrschichtigen Überzug gebildet ist.

Des Weiteren betrifft die Erfindung ein Stahlflachprodukt, das aus einer aus einem Stahlwerkstoff bestehenden Grundschicht und einem darauf aufgetragenen mehrschichtigen Überzug gebildet ist.

Metallische Überzüge werden seit langem zum Schutz von Stahlblechen gegen Korrosion eingesetzt. Neben reinen Zink- oder Aluminiumüberzügen treten dabei in den letzten Jahren zunehmend binäre und ternäre Schichtsysteme. Diese bieten gegenüber den reinen Zink- oder Aluminiumüberzügen neben einem optimierten Korrosionsschutz verbesserte Eigenschaften insbesondere im Hinblick auf Haftung, Abrieb, Schweißbarkeit und Verformbarkeit.

Ternäre Legierungsüberzüge aus Zink, Aluminium und Magnesium, evtl. mit Beimischung geringer Mengen an Silizium, werden üblicherweise durch Schmelztauchbeschichten erzeugt. Die Schichtdicken liegen dabei mit 4 - 10 µm in einem Bereich, in dem es in der Praxis zu Schwierigkeiten beim Verschweißen von derart beschichteten Stahlflachprodukten kommt. Dies gilt insbesondere für das Laserschweißen mit Nullfügespalt, das sich bei mit vergleichbar dicken ternären Überzügen versehenen Stahlblechen als kritisch erwiesen hat.

Dünnere Korrosionsschutzüberzüge mit dennoch hoher Schutzwirkung lassen sich dadurch herstellen, dass ein Stahlsubstrat, d.h. ein Stahlband oder ein -blech, zunächst elektrolytisch mit einer Zinkschicht belegt wird, auf die dann zusätzlich eine Magnesiumschicht aufgetragen wird. Anschließend wird das Magnesium mittels einer Wärmebehandlung in die Zinkschicht unter Bildung von Zn₂Mg einlegiert. Die Beschichtung des elektrolytisch verzinkten Stahlblechs mit dem Mg kann beispielsweise mittels Physical Vapour Deposition (PVD) im Vakuum erfolgen.

Die so erhaltenen Zink-Magnesium-Überzüge auf Basis von Mg-bedampftem elektrolytisch verzinktem Stahlblech besitzen hervorragende Korrosionsschutzeigenschaften und ermöglichen eine deutliche Reduzierung der Auflagendicke, was sich insbesondere in Bezug auf die Verschweißbarkeit positiv auswirkt.

Als für die praktische Herstellung schwierig und aufwändig herausgestellt hat sich bei den ZnMg-Schichtsystemen allerdings, dass die Zinkoberfläche vor dem Bedampfen mit Magnesium möglichst vollständig frei von oxidischen oder sulfidischen Partikeln sein muss. Andernfalls stellt sich eine schlechte Haftung der Zink-Magnesium-Schicht nach der thermischen Nachbehandlung ein.

Der Forderung nach einer weitestgehend oxid- und sulfidfreien Oberfläche steht in der Praxis allerdings entgegen, dass es im Zuge der elektrolytischen Beschichtung und des anschließenden Kontakts mit der Umgebungsatmosphäre unter betrieblichen Bedingungen zur Bildung von Oxiden und Sulfiden kommt. Vor dem Abscheiden der Mg-Schicht auf der Zinkschicht müssen sie daher wieder von der Oberfläche der Zinkschicht entfernt werden.

Eine Möglichkeit einer entsprechenden Behandlung besteht darin, die Zn-Oberfläche vor dem Bedampfen im Vakuum einer Plasmafeinreinigung zu unterziehen. Dabei findet ein Beschuss der Oberfläche mit Argonionen statt, so dass die dort vorhandenen Oxide herausgelöst werden. In der Praxis kann die Plasmafeinreinigung, wie in der EP 0 780 485 B1 (DE 696 10 064 T2) beschrieben, als inverses Magnetronsputterätzen durchgeführt werden.

Die Plasmafeinreinigung hat den Vorteil, dass sie vergleichbar gut beherrschbar ist. Daher wird eine solche Plasmafeinreinigung in der Regel bei allen bekannten Beschichtungsverfahren eingesetzt, bei der ein Metall unter Vakuum auf ein Substrat abgeschieden wird.

Unter Berücksichtigung der Bedingungen, die bei der Verarbeitung von Stahlflachprodukten herrschen, sind die bekannten Verfahren zur Plasmafeinreinigung allerdings großtechnisch nur mit sehr großem Aufwand anwendbar. So fallen einerseits hohe Investitionskosten für die benötigte Anlagentechnik an. Gleichzeitig weisen diese Anlagen nur geringe Standzeiten auf und verlangen kurze Wartungsintervalle, da das durch den Ionenbeschuss abgetragene Oberflächenmaterial in der Anlage verbleibt. Dementsprechend muss es in kurzen Zeitabständen entfernt werden, um eine Kontaminierung des jeweils zu verarbeitenden Flachprodukts mit in der Plasmafeinreinigungsanlage vorhandenen Rückständen zu vermeiden.

Um WO 2006/089832 A1 bzw die aufwändige Plasmafeinreinigung zu umgehen, ist in der DE 10 2005 045 780 A1 vorgeschlagen worden, das zu beschichtende Stahlstahlflachprodukt nach der elektrolytischen Zn-Beschichtung durch eine Kaskadenspüle zu leiten, um die auf der Oberfläche der Zn-Beschichtung vorhandenen Oxide ebenfalls zu entfernen. Anschließend wird dann die Mg-Schicht auf der so gereinigten Zn-Schicht abgeschieden und unter optimierten Betriebsparametern eine thermische Nachbehandlung durchgeführt. Diese soll gewährleisten, dass sich trotz des Verzichtes auf die Plasmafeinreinigung eine ausreichende Haftung des ZnMg-Überzugs auf dem Stahlsubstrat einstellt. Das dabei einzuhaltende Prozessfenster der Glühung ist allerdings so eng, dass es unter praktischen Bedingungen schwierig ist, diese mit der erforderlichen Genauigkeit einzuhalten.

Neben dem voranstehend erläuterten Stand der Technik ist aus dem Artikel von Schuhmacher B. et al. "Novel coating systems based on PVD for steel sheet", Vakuum in Forschung und Praxis, Bd. 13, Nr. 4, August 2001 (2001-08), Seiten 233 - 235, WILEY-VCH, Weinheim, ein Verfahren bekannt, bei dem auf ein Stahlsubstrat durch Elektrogalvanisieren eine Zn-Schicht aufgebracht wird, die nach einem Sputterätzschritt mit einer durch PVD-Beschichten aufgetragenen Magnesiumbeschichtung belegt wird. Eine anschließende Wärmebehandlung führt dann zur Bildung einer Zn-Mg-Legierungsschicht.

Des Weiteren ist aus der WO 2009/059950 A2 ein Verfahren zum Erzeugen eines mit einem vor Korrosion schützenden metallischen Zn-Mg-Überzugs auf einem Stahlsubstrat bekannt, bei dem das Stahlflachprodukt in ein Zn-Mg-Al-Schmelzenbad getaucht wird, welches neben Zn und unvermeidbaren Verunreinigungen (in Gew.-%) 4 - 8 % Mg und 0,5 - 1,8 % Al enthält.

Schließlich ist in der WO 2006/089832 A1 beschrieben, dass eine 50 - 1000 nm dicke Aluminiumschicht durch PVD-Beschichten auf ein Stahlflachprodukt aufgebracht werden kann, bevor der die eigentliche Schutzschicht bildende metallische, hier aus Al, Al/Si oder Zn bestehende Überzug aufgebracht wird. Bei der notwendigerweise vorgeschalteten Glühbehandlung kommt es zu einer Diffusion des Eisens des Stahlflachprodukts in das aufgetragene Al. Im Ergebnis entsteht so im Zuge der anschließenden Glühung auf dem Stahlflachprodukt eine metallische, im Wesentlichen aus Al und Fe bestehende Auflage, die stoffschlüssig mit dem durch das Stahlflachprodukt gebildeten Untergrund verbunden ist. Das auf dem Stahlflachprodukt haftende Al verhindert bei der der Schmelztauchbeschichtung vorgeschalteten Glühung des Stahlflachprodukts einerseits, dass dessen Oberfläche oxidiert. Andererseits wirkt die Al-Schicht bei der Schmelztauchbeschichtung nach Art eines Haftvermittlers, der dafür sorgt, dass der durch das Schmelztauchbeschichten erzeugte Überzug sicher auf dem Stahlflachprodukt haftet.

Vor diesem Hintergrund des voranstehend erläuterten Standes der Technik bestand die Aufgabe der Erfindung darin, ein Verfahren anzugeben, dass es unter praxisgerechten Bedingungen auf vergleichbar einfache Weise erlaubt, ein Stahlflachprodukt mit einem ZnMg-Überzug zu versehen, der nicht nur gut haftet, einen guten Korrosionsschutz bietet und gut verformbar ist, sondern auch noch so dünn eingestellt werden kann, dass das mit ihm versehene Stahlflachprodukt eine gute Verschweißbarkeit besitzt.

Darüber hinaus sollte ein unter praxisgerechten Bedingungen kostengünstig herstellbares Stahlflachprodukt angegeben werden, dass vor Korrosion geschützt ist und dabei eine gute Verform- und Schweißbarkeit besitzt.

In Bezug auf das Verfahren ist diese Aufgabe erfindungsgemäß dadurch gelöst worden, dass die in Anspruch 1 angegebenen Verfahrensschritte durchlaufen werden. Vorteilhafte Ausgestaltungen eines erfindungsgemäßen Verfahrens sind in den auf Anspruch 1 rückbezogenen Ansprüchen angegeben.

In Bezug auf das Stahlflachprodukt besteht die erfindungsgemäße Lösung der oben angegebenen Aufgabe darin, dass ein solches Stahlflachprodukt die in Anspruch 11 angegebenen Merkmale aufweist. Vorteilhafte Ausgestaltungen eines erfindungsgemäßen Produkts sind in den auf Anspruch 11 rückbezogenen Ansprüchen genannt.

Gemäß der Erfindung werden zum Herstellen eines Stahlflachprodukts, das aus einer aus einem Stahlwerkstoff bestehenden Grundschicht und einem darauf aufgetragenen, vor Korrosion schützenden mehrschichtigen Überzug gebildet ist, folgende Arbeitsschritte durchgeführt:
a) Es wird die aus Stahlwerkstoff bestehende Grundschicht des Stahlflachproduktes zur Verfügung gestellt, wobei es sich bei dieser Grundschicht um ein bis dahin unbeschichtetes Stahlband oder Stahlblech handelt.
b) Auf die Grundschicht wird durch elektrolytisches Beschichten eine Zinkschicht aufgebracht.
c) Auf die Oberfläche der Zinkschicht wird eine mindestens 8 nm und höchstens 25 nm dicke Aluminiumschicht aufgebracht. Neben der geringen Dicke dieser Al-Schicht ist dabei wesentlich für die Erfindung, dass die Oberfläche der Zinkschicht hinsichtlich der auf ihr vorhandenen Oxide und Sulfide im verfahrensbedingt am Ende des elektrolytischen Zinkbeschichtens vorliegenden oder auf dem Weg zum Aluminiumbeschichten eintretenden Zustand belassen wird. Dies bedeutet, dass die Al-Schicht unmittelbar auf die Zn-Schicht aufgetragen wird, ohne dass zuvor eine besondere Reinigung oder auf die Entfernung von Oxiden oder Sulfiden gerichtete Vorbehandlung dieser Schicht durchgeführt wird. Das auf die Zn-Schicht aufgetragene Aluminium bindet die dort vorhandenen Zn-Oxide und Sulfide ab.

Erfindungsgemäß wird somit weder eine Plasmafeinreinigung noch eine besondere Spülung oder ein vergleichbares Reinigungsverfahren an dem mit dem Zn-Überzug versehenen Stahlflachprodukt durchgeführt, bevor die Al-Schicht aufgetragen wird. Stattdessen wird erfindungsgemäß bewusst hingenommen, dass auf der Oberfläche der Zn-Schicht Oxide und/oder Sulfide vorhanden sind, die nach herkömmlicher Vorstellung die Entstehung eines ausreichend sicher haftenden Korrosionsschutzüberzugs behindern.

Der erfindungsgemäße Verzicht auf jede auf die Entfernung von Oxiden oder Sulfiden gerichtete Behandlung der Oberfläche der Zinkschicht bewirkt eine deutliche Vereinfachung des erfindungsgemäßen Verfahrens gegenüber den bekannten Verfahren, bei denen eine solche Behandlung als unabdingbar angesehen worden ist.
d) Nach dem Auftrag der Aluminiumschicht wird eine Magnesiumschicht auf die Aluminiumschicht aufgebracht.
e) Der so aufgetragene aus der Zn-Schicht, der Al-Schicht und der Mg-Schicht gebildete Überzug wird abschließend einer Wärmenachbehandelung unterzogen. Die dabei eingestellten Betriebsparameter unterliegen keinen engen Maßgaben, sondern sind lediglich so einzustellen, dass sich in Folge der Wärmezufuhr in Richtung der Oberfläche des Überzugs oberhalb der Al-Schicht eine MgZn₂-Schicht in dem Überzug bildet.

Überraschenderweise hat sich nämlich gezeigt, dass die zwischen der Zn-Schicht und der Mg-Schicht liegende dünne Al-Schicht eine Diffusion des Zinks in die Magnesiumschicht zulässt. Gleichzeitig dient die Al-Schicht als Haftvermittler, der sicherstellt, dass die erfindungsgemäßen Überzüge auch ohne Plasmafeinreinigung bzw. optimierte Temperaturen der thermischen Nachbehandlung oder besonderen Spülbedingungen beim Spülen der Oberfläche der Zn-Schicht vor dem Auftrag der Mg-Schicht eine hervorragende Schichthaftung aufweist.

Wesentlich für den Erfolg der Erfindung ist also, dass die Al-Schicht so dünn aufgetragen wird, dass durch sie noch die Diffusion des Zn in das Mg erfolgen kann. Al-Zwischenschichten sind an sich aus dem Stand der Technik bekannt, werden dort jedoch jeweils als Diffusionsbarrieren genutzt. So wird beispielsweise bei der Feuerverzinkung gezielt eine AlFe-Zwischenschicht gebildet, um die Diffusion von Zn und Fe zu verhindern.

Den voranstehenden Erläuterungen zum erfindungsgemäßen Verfahren entsprechend ist ein erfindungsgemäßes Stahlflachprodukt aus einer aus einem Stahlwerkstoff bestehenden Grundschicht und einem darauf aufgetragenen mehrschichtigen Überzug gebildet, wobei der Überzug erfindungsgemäß eine auf der Grundschicht liegende Zn-Schicht, eine oberflächennahe MgZn₂-Diffusionsschicht und eine zwischen der Zn-Schicht und der MgZn₂-Diffusionsschicht liegende, maximal 25 nm dicke Al-Schicht umfasst. Die Dicke der MgZn₂-Schicht des Überzugs eines erfindungsgemäß beschaffenen Stahlflachproduktes beträgt typischerweise 400 - 2500 nm, wobei sich eine optimale Schutzwirkung bei einer Dicke von 400 - 1000 nm ergibt.

Oberhalb der MgZn₂-Schicht kann noch eine dünne ausschließlich aus Magnesium bestehende Schicht vorhanden sein, die jedoch in der Regel nur die oberen Atomlagen einnimmt .

Die Erfindung beinhaltet somit einen Zink-Magnesium-Überzug, der hergestellt wird, indem auf elektrolytisch beschichtetes Stahlblech zunächst eine dünne Aluminiumschicht zur Haftungsverbesserung abgeschieden wird. Anschließend erfolgt ein Magnesiumauftrag, auf den dann eine thermische Nachbehandlung durchgeführt wird. Im Rahmen dieser thermischen Nachbehandlung bildet sich eine oberflächennahe MgZn₂-Phase. Die dünne Aluminiumschicht mit einer Dicke von weniger als 25 nm dient dabei der Verbesserung der Haftung des Überzugs, ohne dass dazu eine besondere Reinigung der Oberfläche der Zinkschicht vor dem Auftrag der Al-Schicht erforderlich ist. Genauso wenig erfolgt eine Reinigung der Al-Schicht, bevor das Magnesium auf ihr abgeschieden wird.

Ein besonders wirksamer Korrosionsschutz ergibt sich, wenn im Zuge der elektrolytischen Zn-Beschichtung eine vollständig aus hochreinem, bis zu 99,9 Gew.-% aus Zink bestehende Zn-Schicht gebildet wird. Dabei hat sich herausgestellt, dass es für den angestrebten optimierten Korrosionsschutz bei einem erfindungsgemäß aufgebauten und beschaffenen Überzug ausreicht, wenn die Dicke der elektrolytisch abgeschiedenen Zn-Schicht 2 - 10 µm beträgt, wobei es im Hinblick auf die Verschweißbarkeit erfindungsgemäß erzeugter Stahlflachprodukte günstig ist, wenn die Zn-Schicht weniger als 8 µm dick auf die Grundschicht aufgetragen ist.

Die erfindungsgemäß genutzte Wirkung der auf die Zinkschicht aufgetragenen Aluminiumschicht tritt dadurch besonders sicher ein, dass die Al-Schicht mindestens 8 nm dick auf die Zinkschicht aufgetragen wird. Optimal wirkt die Aluminiumschicht, wenn die Dicke der Aluminiumschicht 8,5 - 13 nm beträgt.

Als Verfahren zum Abscheiden der dünnen Al-Schicht eignen sich Kathodenzerstäubungsverfahren, insbesondere das Magnetronsputtern. Unabhängig davon, welches Beschichtungsverfahren konkret eingesetzt wird, besteht der entscheidende Vorteil der erfindungsgemäßen Vorgehensweise gegenüber dem Stand der Technik darin, dass das aufgebrachte Al mit dem Stahlflachprodukt die Anlage verlässt. Im Gegensatz zu Verfahren, bei denen eine mit einem Materialabtrag einhergehende Plasmafeinreinigung angewendet werden muss, um eine ausreichende Haftung des ZnMg-Überzugs zu sichern, gefährden bei dem erfindungsgemäßen Verfahren somit weder abgereinigte Oxide noch rekondensierende Metalle das Arbeitsergebnis. Stattdessen kann die erfindungsgemäß zur Erzeugung der Al-Schicht eingesetzte Anlage störungs- und unterbrechungsfrei über eine lange Einsatzdauer betrieben werden.

Indem die Magnesiumschicht 200 - 1500 nm dick auf die Aluminiumschicht aufgetragen wird, tritt die Schutzwirkung der Mg-Schicht zuverlässig ein. Eine optimale Wirkung ist dabei dann gewährleistet, wenn die Schichtdicke der auf die Al-Schicht aufgetragenen Mg-Schicht vor der abschließenden Wärmenachbehandlung 300 - 800 nm beträgt.

Um die bei der Wärmenachbehandlung ablaufende Diffusion des Zinks durch die Al-Schicht in die Mg-Schicht betriebssicher zu bewirken, sollte die Temperatur der Wärmenachbehandlung 280 - 350 °C betragen, wobei sich eine Nachbehandlungstemperatur von 325 +/- 10 °C als besonders günstig erwiesen hat. Typischerweise beträgt die Dauer der Wärmebehandlung 5 - 30 Sekunden.

Nachfolgend wird die Erfindung anhand von Ausführungsbeispielen näher erläutert.

Zum Nachweis der Wirkung der Erfindung sind verschiedene Versuche durchgeführt worden, deren allgemeiner Verfahrensablauf wie folgt beschrieben werden kann:

Auf ein die Grundschicht des herzustellenden Stahlfachproduktes bildendes Stahlband, das aus einem IF-Stahl der Güte DC 06 bestand, ist im kontinuierlichen Durchlauf elektrolytisch eine zu 99,9 Gew.-% aus Zink bestehende hochreine, 2,5 µm dicke Zn-Schicht abgeschieden worden.

Das so mit einer Zn-Beschichtung versehene Stahlband ist unmittelbar anschließend unter Fortsetzung des kontinuierlichen Verfahrensablaufs direkt einer konventionellen Magnetronsputter-Einrichtung zugeführt worden, in der es ohne vorhergehende Entfernung der auf seiner Oberfläche vorhandenen Oxide und/oder Sulfide mit einer dünnen Al-Schicht bedampft worden ist.

Im Anschluss daran ist das mit der Zn-Schicht und der darauf liegenden Al-Schicht beschichtete Stahlsubstrat dann jeweils unter Beibehaltung des kontinuierlichen Verfahrensablaufs einer ebenso konventionellen PVD-Beschichtungsanlage (PVD = "Physical Vapour Deposition") zugeführt worden, in der unter Vakuum eine 300 nm dicke Mg-Schicht auf der Al-Schicht abgeschieden worden ist.

Abschließend erfolgt dann jeweils eine Wärmenachbehandlung, bei der das aus der aus dem Stahlwerkstoff bestehenden Grundschicht und darauf liegenden, aus der Zn-Schicht, der Al-Schicht und der Mg-Schicht gebildeten Überzug bestehende Stahlflachprodukt für 10 s bei 320 °C gehalten worden ist. Auf diese Weise hat sich in dem Überzug des Stahlflachprodukts ein Schichtaufbau eingestellt, bei dem auf der Stahl-Grundschicht eine im Wesentlichen aus Zn bestehende Schicht vorhanden war, auf der eine Zinkoxide und Sulfide enthaltende dünne Schicht lag, die wiederum von der Al-Schicht abgedeckt war. Auf der Al-Schicht lag wiederum eine MgZn₂-Schicht, die von einer wenige Atomlagen dicken reinen Mg-Schicht bedeckt war.

Die Dicke der Al-Schicht einer ersten erfindungsgemäßen Probe E1 ist durch eine entsprechende Einstellung der Leistung des Magnetronsputters auf 8,5 nm eingestellt worden. In entsprechender Weise ist die Dicke der Al-Schicht einer zweiten erfindungsgemäßen Probe E2 auf 10,5 nm und die Dicke der Al-Schicht einer dritten erfindungsgemäßen Probe E3 auf 13 nm eingestellt worden.

Zum Vergleich ist eine erste nicht erfindungsgemäße Probe V1 in konventioneller Weise durch elektrolytisches Verzinken, anschließende Plasmafeinreinigung und Abscheiden einer Mg-Schicht durch ein PVD-Verfahren sowie anschließendes Wärmenachbehandeln bei 320 °C mit einem ZnMg-Überzug versehen worden.

Ebenfalls zum Vergleich ist eine zweite nicht erfindungsgemäße Probe V2 in konventioneller Weise durch elektrolytisches Verzinken und Abscheiden einer Mg-Schicht durch ein PVD-Verfahren sowie anschließendes Wärmenachbehandeln bei 320 °C mit einem ZnMg-Überzug versehen worden. Vor dem Auftrag der Mg-Schicht wurde in diesem Fall keine Behandlung zur Entfernung der auf der Zn-Schicht vorhandenen Oxide und Sulfide durchgeführt.

Als erste Untersuchung wurde an den Proben E1, E2, E3, V1, V2 ein Kleberaupenbiegetest durchgeführt. Dazu sind etwa 150 mm lange Streifen des jeweiligen Probenmaterials verwendet worden.

Nach einem definierten Beölen ist auf diese Streifen jeweils eine Kleberaupe eines konventionellen, unter dem Handelsnamen Betamate 1496 erhältlichen Klebers aufgetragen worden.

Nach dem Aushärten des Klebers ist der Streifen zunächst bei Raumtemperatur RT schlagartig um eine quer zu seiner Längserstreckung ausgerichtete Achse umgefaltet worden. In der gleichen Weise sind entsprechende Proben anschließend bei -20 °C umgeformt worden. Im Zuge der jeweiligen Umformung kam es zur Ablösung und zum Bruch des Klebstoffs.

Die Oberfläche der Proben, von der sich der Kleber gelöst hat, ist dann visuell beurteilt worden. Dabei ist unterschieden worden, ob die Ablösung innerhalb des metallischen Überzugs stattgefunden hat (so genannter "Delaminationsbruch" = "DF") oder entweder zwischen Klebstoff und metallischer Oberfläche oder innerhalb des Klebstoffs (so genannter "Mischbruch" = "MF"). Ebenso visuell sind die Anteile der Bruchfläche der Kleberraupen der jeweiligen Proben bestimmt worden. Ein Delaminationsbruchanteil von mehr als 5 % bei Raumtemperatur ist als unerwünscht angesehen worden, da er auf Haftungsprobleme des Überzugs hindeutet. In Tabelle 1 sind die Ergebnisse der so durchgeführten Beurteilungen zusammengefasst:

**Tabelle 1**

| | | DF | MF | DF | MF |
|---|---|---|---|---|---|
| | Temperatur: | RT | RT | -20°C | -20°C |
| | | Bruchflächenanteile | | | |
| V1 | | 0% | 100% | 0% | 100% |
| V2 | | 40% | 60% | 95% | 5% |
| E1 | | 0% | 100% | 5% | 95% |
| E2 | | 0% | 100% | 5% | 95% |
| E3 | | 0% | 100% | 20% | 80% |

Die Ergebnisse zeigen, dass bei der Vergleichsvariante V1, die eine Plasmafeinreinigung vor dem Auftrag der Mg-Schicht durchlaufen hat, bis zu 100 % Mischbruch vorliegt.

Verzichtet man auf die Plasmafeinreinigung, so zeigt Vergleichsversuch V2, dass sich in diesem Fall ohne die erfindungsgemäße dünne Aluminiumschicht bei Raumtemperatur bereits ein hoher Delaminationsbruchanteil einstellt, der bei -20 °C auf mehr als 90 % ansteigt.

Die mit den erfindungsgemäßen Proben E1- E3 durchgeführten Versuche belegen dagegen, dass sehr dünne Al-Schichten von ca. 8,5 nm bei Raumtemperatur einen Mischbruchanteil von 100 % ergeben, der auch noch bei -20 °C über 90 % liegt. Damit führt die erfindungsgemäß zwischen den Zn- und Mg-Schichten vorgesehene Al-Schicht zu einer deutlichen Verbesserung gegenüber den Vergleichsvarianten V1, V2.

Zusätzlich sind an weiteren Proben E1 - E3 und V1,V2 Zug-Scherprüfungen durchgeführt worden.

Bei der Zug-Scherprüfung werden zwei Streifen miteinander verklebt, wobei auch hier der Klebstoff Betamate 1496 verwendet worden ist. Die miteinander verklebten Proben werden dann bei Raumtemperatur und -20 C° auf Zug beansprucht, bis die Klebestelle reißt.

Dieser Test ist bei einem ersten Teil der Proben E1 - E3 und V1, V2 im kurzen zeitlichen Abstand auf die Verklebung und bei einem anderen Teil der Proben E1 - E3, V1, V2 erst nach 30 Tagen Alterung durchgeführt worden.

In den nachfolgend wiedergegebenen Tabellen 2 - 5 bedeuten die Kürzel
"SF" : Bruch im Stahlgrundwerkstoff,
"DF" : Delaminationsbruch, d. h. Trennung im Überzug,
"AF" : Adhäsionsbruch, d. h. Trennung zwischen Klebstoff und Oberfläche,
"SCF": oberflächennaher Kohäsionsbruch, d. h. Bruch im Klebstoff nahe der Oberfläche,
"CF" : Kohäsionsbruch, d. h. Bruch im Klebstoff.

In Tabelle 2 sind die bei den sofort nach dem Verkleben bei Raumtemperatur durchgeführten Zug-Scherversuchen ermittelten Bruchflächenanteile angegeben.

**Tabelle 2**

| | CF | SCF | AF | DF | DF |
|---|---|---|---|---|---|
| Proben | Bruchflächenanteile [%] | | | | |
| V1 | 0 | 70,8 | 29,2 | 0 | 0 |
| V2 | 0 | 62,3 | 17,5 | 20,2 | 0 |
| E1 | 0 | 84,2 | 13,3 | 2,5 | 0 |
| E2 | 0 | 75,2 | 24,8 | 0 | 0 |
| E3 | 0 | 83,2 | 16,8 | 0 | 0 |

In Tabelle 3 sind die Bruchflächenanteile angegeben, die nach einer Lagerung von 30 Tagen nach dem Verkleben bei Raumtemperatur durchgeführten Zug-Scherversuchen ermittelt worden sind.

**Tabelle 3**

| | CF | SCF | AF | DF | SF |
|---|---|---|---|---|---|
| Proben | Bruchflächenanteile [%] | | | | |
| V1 | 14,2 | 70 | 15,8 | 0 | 0 |
| V2 | 6,7 | 48,3 | 3,3 | 41,7 | 0 |
| E1 | 10 | 63,3 | 2,5 | 24,2 | 0 |
| E2 | 12,5 | 66,7 | 5,8 | 15 | 0 |
| E3 | 6,7 | 80,8 | 7,5 | 5 | 0 |

In Tabelle 4 sind die bei den sofort nach dem Verkleben bei -20 °C durchgeführten Zug-Scherversuchen ermittelt Bruchflächenanteile angegeben.

**Tabelle 4**

| | CF | SCF | AF | DF | SF |
|---|---|---|---|---|---|
| Proben | Bruchflächenanteile [%] | | | | |
| V1 | 0 | 50 | 50 | 0 | 0 |
| V2 | 0 | 15 | 1,7 | 83,3 | 0 |
| E1 | 0 | 25 | 35 | 40 | 0 |
| E2 | 0 | 39,5 | 52,8 | 7,7 | 0 |
| E3 | 0 | 30 | 65,8 | 4,2 | 0 |

In Tabelle 5 sind die Bruchflächenanteile angegeben, die nach einer Lagerung von 30 Tagen nach dem Verkleben bei -20 °C durchgeführten Zug-Scherversuchen ermittelt worden sind.

**Tabelle 5**

| | CF | SCF | AF | DF | SF |
|---|---|---|---|---|---|
| Proben | Bruchflächenanteile [%] | | | | |
| V1 | 0 | 85 | 0 | 15 | 0 |
| V2 | 0 | 22 | 0 | 78 | 0 |
| V1 | 0 | 85 | 0 | 15 | 0 |
| V2 | 0 | 22 | 0 | 78 | 0 |
| E1 | 0 | 40 | 0 | 60 | 0 |
| E2 | 0 | 61,7 | 0 | 38,3 | 0 |
| E3 | 0 | 65 | 0 | 35 | 0 |

Die Ergebnisse der Zug-Scherprüfung zeigen eine klare Tendenz. Beim ohne Plasmafeinreinigung erzeugten Vergleichsbeispiel V2 tritt unter allen Versuchsbedingungen ein deutlicher Delaminationsbruchanteil auf, der eine unerwünschte Größe erreicht.

Bei mit Plasmafeinreinigung hergestellten Vergleichsbeispiel V1 tritt ein solcher Anteil nur nach 30 Tagen bei -20 °C auf.

Die Abscheidung einer dünnen Aluminiumschicht führt dagegen zu einer signifikanten Verbesserung, da der Delaminationsanteil bei jeder der untersuchten erfindungsgemäßen Proben E1 - E3 geringer ausfällt. Auffällig ist hierbei der Einfluss der Dicke der Aluminiumschicht. Bei allen Versuchsbedingungen reduziert sich der Delaminationsanteil mit zunehmender Dicke der Aluminiumschicht.

## Patentansprüche

1. Verfahren zum Herstellen eines Stahlflachprodukts, das aus einer aus einem Stahlwerkstoff bestehenden Grundschicht und einem darauf aufgetragenen, vor Korrosion schützenden mehrschichtigen Überzug gebildet ist, umfassend folgende Arbeitsschritte:
- Zurverfügungstellen der Grundschicht,
- Aufbringen einer Zinkschicht auf die Grundschicht durch elektrolytisches Beschichten,
- Aufbringen einer mindestens 8 nm und höchstens 25 nm dicken Aluminiumschicht auf die Oberfläche der Zinkschicht, wobei die Oberfläche der Zinkschicht hinsichtlich der auf ihr vorhandenen Oxide und Sulfide im verfahrensbedingt am Ende des elektrolytischen Zinkbeschichtens vorliegenden oder auf dem Weg zum Aluminiumbeschichten eintretenden Zustand belassen ist,
- Aufbringen einer Magnesiumschicht auf die Aluminiumschicht und
- Wärmenachbehandeln des mit dem aus der auf die Grundschicht aufgebrachten Zinkschicht, der Aluminiumschicht und der Magnesiumschicht gebildeten Überzugs versehenen Stahlflachprodukts derart, dass sich in Richtung der Oberfläche des Überzugs oberhalb der Al-Schicht eine MgZn₂-Schicht in dem Überzug bildet.

2. Verfahren nach Anspruch 1, **dadurch gekennzeichnet, dass** die Zinkschicht aus hochreinem Zink gebildet ist.

3. Verfahren nach Anspruch 2, **dadurch gekennzeichnet, dass** die Zinkschicht zu 99,9 Gew.-% aus Zn besteht.

4. Verfahren nach einem der voranstehenden Ansprüche, **dadurch gekennzeichnet, dass** die Zinkschicht 2 - 10 µµm dick auf die Grundschicht aufgetragen wird.

5. Verfahren nach Anspruch 4, **dadurch gekennzeichnet, dass** die Zinkschicht weniger als 8 µm dick auf die Grundschicht aufgetragen wird.

6. Verfahren nach einem der voranstehenden Ansprüche, **dadurch gekennzeichnet, dass** die auf die Zinkschicht aufgetragene Aluminiumschicht 8,5 - 13 nm dick ist.

7. Verfahren nach einem der voranstehenden Ansprüche, **dadurch gekennzeichnet, dass** die Aluminiumschicht durch ein Kathodenzerstäubungsverfahren aufgetragen wird.

8. Verfahren nach einem der voranstehenden Ansprüche, **dadurch gekennzeichnet, dass** die Magnesiumschicht 200 - 1500 nm dick auf die Aluminiumschicht aufgetragen wird.

9. Verfahren nach Anspruch 8, **dadurch gekennzeichnet, dass** die auf die Aluminiumschicht aufgetragene Magnesiumschicht 300 - 800 nm dick ist.

10. Verfahren nach einem der voranstehenden Ansprüche, **dadurch gekennzeichnet, dass** die Temperatur der Wärmenachbehandlung 280 - 350 °C beträgt.

11. Stahlflachprodukt, das aus einer aus einem Stahlwerkstoff bestehenden Grundschicht und einem darauf aufgetragenen mehrschichtigen Überzug gebildet ist, **dadurch**
**gekennzeichnet, dass** der Überzug eine auf der Grundschicht liegende Zn-Schicht, eine oberflächennahe MgZn₂-Diffusionsschicht und eine zwischen der Zn-Schicht und der MgZn₂-Diffusionsschicht liegende, mindestens 8 nm und maximal 25 nm dicke Al-Schicht umfasst.

12. Stahlflachprodukt nach Anspruch 11, **dadurch gekennzeichnet, dass** die Dicke der MgZn₂-Schicht 400 - 2500 nm beträgt.

13. Stahlflachprodukt nach einem der Ansprüche 11 oder 12, **dadurch gekennzeichnet, dass** es durch ein gemäß einem der Ansprüche 1 bis 10 ausgestalteten Verfahren hergestellt ist.

## Claims

1. Method for the production of a flat steel product that is formed from a base layer consisting of a steel material and a multilayer anticorrosion coating applied thereto, comprising the following operating steps:
- provision of the base layer,
- application of a zinc layer to the base layer by electrolytic coating,
- application of an at least 8 nm and at most 25 nm thick aluminium layer to the surface of the zinc layer, the surface of the zinc layer having regard to the oxides and sulphides present thereon being left in the state existing at the end of the electrolytic zinc coating or occurring on the way to the aluminium coating as a result of the method,
- application of a magnesium layer to the aluminium layer, and
- thermal post-treatment of the flat steel product provided with the coating formed from the zinc layer applied to the base layer, the aluminium layer and the magnesium layer, in such a way that an MgZn₂ layer is formed in the coating above the Al layer in the direction of the surface of the coating.

2. Method according to claim 1, **characterised in that** the zinc layer is formed of high purity zinc.

3. Method according to claim 2, **characterised in that** the zinc layer consists up to 99.9 wt.% of Zn.

4. Method according to any one of the preceding claims, **characterised in that** the zinc layer is applied in a thickness of 2 - 10 µm to the base layer.

5. Method according to claim 4, **characterised in that** the zinc layer is applied in a thickness of less than 8 µm to the base layer.

6. Method according to any one of the preceding claims, **characterised in that** the aluminium layer applied to the zinc layer is 8.5 - 13 nm thick.

7. Method according to any one of the preceding claims, **characterised in that** the aluminium layer is applied by a cathode sputtering method.

8. Method according to any one of the preceding claims, **characterised in that** the magnesium layer is applied in a thickness of 200 - 1500 nm to the aluminium layer.

9. Method according to claim 8, **characterised in that** the magnesium layer applied to the aluminium layer is 300 - 800 nm thick.

10. Method according to any one of the preceding claims, **characterised in that** the temperature of the thermal post-treatment is 280° - 350°C.

11. Flat steel product that is formed from a base layer consisting of a steel material and a multilayer coating applied thereto, **characterised in that** the coating comprises a Zn layer lying on the base layer, an MgZn₂ diffusion layer close to the surface, an at least 8 nm and at most 25 nm thick Al layer lying between the Zn layer and the MgZn₂ diffusion layer.

12. Flat steel product according to claim 11, **characterised in that** the thickness of the MgZn₂ layer is 400 - 2500 nm.

13. Flat steel product according to any one of claims 11 or 12, **characterised in that** it is produced by a method carried out according to any one of claims 1 to 10.

## Revendications

1. Procédé pour la fabrication d'un produit plat en acier, qui est composé d'une couche de base, qui consiste en un matériau acier, et d'un revêtement, qui est appliqué en plusieurs couches sur celle-ci, lequel procédé comprend les étapes suivantes:
- mise à disposition de la couche de base,
- application d'une couche de zinc sur la couche de base, par revêtement électrolytique,
- application, sur la surface de la couche de zinc, d'une couche d'aluminium d'une épaisseur de 8 nm au minimum et de 25 nm au maximum, sachant que la surface de la couche de zinc, en ce qui concerne des oxydes et des sulfites présents, est laissée à l'état résultant du procédé à la fin du revêtement électrolytique de zinc ou se produisant au cours du revêtement avec la couche d'aluminium,
- application d'une couche de magnésium sur la couche d'aluminium, et
- traitement à chaud du produit plat en acier pourvu du revêtement composé de la couche de zinc, appliquée sur la couche de base, de la couche d'aluminium et de la couche de magnésium, de sorte que, dans la direction de la surface du revêtement, une couche de MgZn₂ se forme dans le revêtement, au-dessus de la couche d'aluminium.

2. Procédé selon la revendication 1, **caractérisé en ce que** la couche de zinc consiste en zinc de grande pureté.

3. Procédé selon la revendication 2, **caractérisé en ce que** la couche de zinc contient 99,9 % en poids de Zn.

4. Procédé selon l'une des revendications précédentes, **caractérisé en ce que** la couche de zinc, appliquée sur la couche de base, présente une épaisseur de 2 à 10 µm.

5. Procédé selon la revendication 4, **caractérisé en ce que** la couche de zinc, appliquée sur la couche de base, présente une épaisseur de moins de 8 µm.

6. Procédé selon l'une des revendications précédentes, **caractérisé en ce que** la couche d'aluminium, appliquée sur la couche de zinc, présente une épaisseur de 8,5 à 13 nm.

7. Procédé selon l'une ou plusieurs des revendications précédentes, **caractérisé en ce que** la couche d'aluminium est appliquée selon un procédé de pulvérisation cathodique.

8. Procédé selon l'une des revendications précédentes, **caractérisé en ce que** la couche de magnésium, appliquée sur la couche d'aluminium, a une épaisseur de 200 à 1500 nm.

9. Procédé selon la revendication 8, **caractérisé en ce que** la couche de magnésium, appliquée sur la couche d'aluminium a une épaisseur de 300 à 800 nm.

10. Procédé selon l'une des revendications précédentes, **caractérisé en ce que** la température du traitement ultérieur à chaud est de 280 à 350 °C.

11. Produit plat en acier, qui est composé d'une couche de base en un matériau acier et d'un revêtement appliqué en plusieurs couches sur celle-ci, **caractérisé en ce que** le revêtement comprend une couche de Zn appliquée sur le couche de base, une couche de diffusion de MgZn₂ proche de la surface, et, entre la couche de Zn et la couche de diffusion de MgZn₂, une couche d'aluminium d'une épaisseur de 8 nm au minimum et de 25 nm au maximum.

12. Produit plat en acier selon la revendication 11, **caractérisé en ce que** l'épaisseur de la couche de MgZn₂ est de 400 à 2500 nm.

13. Produit plat en acier selon l'une des revendications 11 ou 12, **caractérisé en ce qu'**il est fabriqué selon un procédé conforme à l'une des revendications 1 à 10.
